# EUROPÄISCHE PATENTANMELDUNG

(11) **EP 0 971 048 A1**
(43) Veröffentlichungstag der Anmeldung: **12.01.2000**
(21) Anmeldenummer: 99111615.3
(22) Anmeldetag: 15.06.1999
(51) Int. Cl.: C23C 16/30, C23C 14/06, C23C 16/26, C23C 28/04

(54) **Amorphen Kohlenstoff enthaltende Schicht und Verfahren zu deren Herstellung**

(30) Priorität: 15.06.1998 DE 19826239
(71) Anmelder: Fraunhofer-Gesellschaft zur Förderung der angewandten Forschung e.V., 80636 München (DE)
(72) Erfinder: Bewilogue, Klaus, Dr., 38110 Braunschweig (DE); Wittorf, Ralf, 38110 Braunschweig (DE); Hieke, André, 38162 Hordorf (DE); Dimigen, Heinz, 22605 Hamburg (DE)
(74) Vertreter: Einsel, Martin, Dipl.-Phys.

(57) **Zusammenfassung**

Die vorliegende Erfindung betrifft ein Verfahren zur Herstellung von Hartstoffschichten auf Basis von amorphen Kohlenwasserstoff, die gegebenenfalls zusätzlich weitere Elemente insbesondere metallische Elemente, enthalten können, mittels eines modifizierten PVD-Verfahrens sowie nach diesem Verfahren erhältliche Hartstoffschichten auf Basis von amorphen Kohlenwasserstoff.

## Beschreibung

Die vorliegende Erfindung betrifft eine amorphen Kohlenstoff enthaltende verschleiß- und reibungsmindernde Schicht sowie Verfahren für deren Herstellung. Insbesondere betrifft die vorliegende Erfindung eine derartige Schicht, die neben den Basiselementen Kohlenstoff und Wasserstoff sowie gegebenenfalls nichtmetallischen und halbmetallischen Zusatzelementen metallische Elemente enthalten kann.

Diese Schichten können sowohl als reibungsmindernde Verschleißschutzschichten als auch als Schichten mit definiert einstellbaren Benetzungs- bzw. Adhäsionsverhalten für ein breites Anwendungsgebiet eingesetzt werden und eignen sich insbesondere als Funktionsschichten für Bauteile und Werkzeuge in den verschiedensten Industriebereichen.

Sogenannte Hartstoffschichten aus amorphen Kohlenwasserstoff, abgekürzt a-C:H-Schichten oder auch DLC-Schichten (diamond-like-carbon) bezeichnet, sind allgemein bekannt und vielfältig in der Literatur beschrieben (z. B. R.E. Clausing et al., 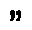 Diamond and diamond-like films and coatings, Plenum Press, New York 1991).
Sie zeichnen sich insbesondere durch niedrige Reibwerte (Kenngröße für Reibkräfte zwischen zwei Flächen, z. B. bei Kugellagern), z. B. von < 0,2 gegen Stahl, hohe Härte und Verschleißbeständigkeit aus.

Es ist weiter bekannt, das Benetzungs- bzw. Adhäsionsverhalten dieser a-C:H-Schichten durch Zusatz von nichtmetallischen und/oder halbmetallischen Elementen X der ersten, dritten, vierten, fünften, sechsten und/oder siebten Hauptgruppe des Periodensystems der Elemente, wie z. B. Bor, Silicium, Sauerstoff, Stickstoff und/oder Fluor, definiert für den jeweiligen Anwendungsfall einzustellen (z. B. EP-0-A 625 588).

Diese amorphen Kohlenwasserstoffschichten, die neben den Basiselementen Kohlenstoff und Wasserstoff noch gegebenenfalls nichtmetallische und halbmetallische Elemente enthalten können, werden herkömmlicher Weise mittels einem PACVD-Prozeß (Plasma-Activated-Chemical-Vapor-Deposition) hergestellt, indem sie auf einem Substrat abgeschieden werden. Dabei wird durch Anlegen einer Hochfrequenz-Spannung mit Frequenzen > 1 MHZ, in der Regel 13,56 MHZ, an zwei in einem Hochvakuum befindliche Elektroden nach dem Einleiten eines geeigneten Gases ein Plasma gezündet und das zu beschichtende Substrat in einem kathodischen Abscheidungsprozeß beschichtet.
Als Plasmagase werden üblicherweise reaktive Kohlenwasserstoffgase, insbesondere Acytelen (C₂H₂) oder Methan (CH₄), verwendet. Die Kohlenwasserstoffmoleküle werden dabei im Plasma in unterschiedliche Bruchstücke aufgespalten und teilweise positiv ionisiert. Die positiv geladenen Teilchen werden in Richtung des auf negativen Potential liegenden Substrates beschleunigt, auf dem Substrat abgeschieden und polymerisieren dort als Kohlenwasserstoffschicht. Zur Herstellung von Funktionsschichten, die neben den Basiselementen Zusatzelemente wie die vorstehend beschriebenen nichtmetallischen und/oder halbmetallischen Elemente enthalten sollen, werden dem Reaktivgas entsprechende gasförmige Verbindungen dieser Elemente zugesetzt. Eine ausführliche Beschreibung der Herstellung derartiger Funktionsschichten findet sich in der vorstehend genannten EP-A 0 625 588.

Von Nachteil ist jedoch, daß die Reibwerte dieser Schichten von der Luftfeuchtigkeit beeinflußt werden können. Zudem lassen sich mittels der vorstehend beschriebenen plasmaaktivierten CVD-Technik qualitativ hochwertige a-C:H- und a-C:H:X-Schichten nur in relativ kleinem Maßstab erhalten, d. h. diese Technik eignet sich nicht für die Herstellung in großindustriellen Dimensionen.
Ein weiterer Nachteil dieser Schichten sind die hohen Druckeigenspannungen, die vor allem auf dem technisch besonders bedeutsamen Stahlsubstraten schnell zum Enthaften der Schichten führen können. Um eine gute Haftung zu erreichen, müssen daher spezielle Zwischenschichten aufgebracht werden, die jedoch das Herstellungsverfahren komplizieren und damit teurer machen.

In der EP-A 0 087 836 wird der Einbau von metallischen Zusatzelementen in eine Funktionsschicht aus amorphen Kohlenstoff vorgeschlagen, wodurch eine Funktionsschicht erhalten werden kann, deren Reibwert von der Luftfeuchtigkeit nahezu unabhängig ist und dennoch mit den niedrigen Reibwerten von reinen amorphen Kohlenwasserstoffschichten vergleichbar ist.
Diese als Me-C:H oder Me-DLC bezeichneten Schichten lassen sich z. B. mittels PVD (Physical-Vapor-Deposition)-Verfahren wie Sputterverfahren oder Bogenverdampfung (Arc-Verfahren) auf einem Substrat abscheiden, wobei Metalle oder Metallcarbide als Targetmaterialien verwendet werden. Die in die Schichten einzubauenden Metalle können auch durch Verdampfung, z. B. mit dem Ionenplattierverfahren, erzeugt werden.

Das Substrat, das gleichzeitig als Elektrode dient, wird hierbei mit Gleichspannung (DC) betrieben.

Der Metallgehalt in den Schichten wird dabei über die Zusammensetzung des Sputtergases, das üblicherweise ein Edelgas wie Argon und der entsprechende Kohlenwasserstoff ist, eingestellt.

Anders als bei den PA-CVD-Verfahren zur Herstellung von Schichten aus amorphen Kohlenstoff lassen sich diese Me-C:H-Schichten auch im großindustriellen Maßstab in DC-Magnetron-Sputteranlagen herstellen.

Falls erforderlich, lassen sich nach diesem Verfahren auf einfache Art und Weise auch haftvermittelnde Schichten durch Abstäuben des Metalltargets als ersten Schritt bei der Me-C:H-Abscheidung herstellen.

Im Gegensatz zu den a-C:H- und a-C:H:X-Schichten besitzen die Me-C:H-Schichten eine um mehrere Größenordnungen höhere elektrische Leitfähigkeit und eignen sich daher auch für Anwendungen, für die Funktionsschichten mit elektrischer Leitfähigkeit erforderlich oder vorteihaft sind, z. B. für Steckverbinder.

Ein großer Nachteil von bekannten Me-C:H-Schichten ist jedoch deren deutlich verminderte Verschleißbeständigkeit im Vergleich zu den Schichten aus amorphen Kohlenwasserstoff. So sind selbst die niedrigsten Verschleißwerte, die für Metall-Kohlenstoff-Verhältnisse (Me/C) zwischen 0,1 und 0,2 erzielt werden, deutlich schlechter als die von Schichten aus reinem amorphen Kohlenwasserstoff. Bei geringeren Metallanteilen (Me/C < 0,1) nimmt der Verschleiß so erheblich zu, daß solche Schichten für die Oberflächenvergütung von beispielsweise Bauteilen ungeeignet sind.

In DE 34 42 208 wird eine Magnetronentladung mit einer metallischen Kathode genutzt, um ein intensives Plasma zu erzeugen. Beim Einlassen von gasförmigen Kohlenwasserstoffen in den Kathodenentladungsbereich kommt es zur Zersetzung der Kohlenwasserstoffe und zur Abscheidung einer a-C:H-Schicht auf dem Substrat. Dieses ist dabei über eine Kapazität an einen Hochfrequenzgenerator (13,56 MHz) angeschlossen. Die negative Spannung an der Substrateleketrode dient dem zusätzlichen Ionenbeschuß der wachsenden Schicht.

Neben den vorstehend beschriebenen Verfahren zur Abscheidung von Hartstoffschichten auf Basis von amorphen Kohlenstoff, die alle Gleichstrom für die Substratbeschaltung verwenden, ist die Abscheidung von Hartstoffschichten auf Titannitrid-Basis mittels gepulstem Gleichstrom bekannt (M. Griepentrog, B. Mackrodt, G. Mark, T. Linz 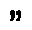 Properties of TiN hard coatings prepared by unbalanced magnetron sputtering and cathodic arc deposition using a uni- and bipolar pulsed bias voltage", Surface & Coatings Technology 74- 75 (1995) 326 - 332).

Der Erfindung liegt die Aufgabe zugrunde, Hartstoffschichten auf Basis von amorphen Kohlenwasserstoff zur Verfügung zu stellen, die einerseits nicht die Nachteile von reinen a-C:H-Schichten wie luftfeuchtigkeitsabhängige Reibwerte und nur im kleinen Maßstab durchzuführende Herstellungsverfahren aufweisen und dennoch eine Verschleißbeständigkeit besitzen, die mit der von reinen a-C:H-Schichten vergleichbar ist.

Erfindungsgemäß soll zudem ein Verfahren zur Verfügung gestellt, mit dem Hartstoffschichten auf Basis von amorphen Kohlenwasserstoff, insbesondere auch reine a-C:H-Schichten, im großindustriellen Maßstab, insbesondere unter Verwendung von herkömmlichen Anlagen, wie sie bereits zur Herstellung von Me-C:H-Schichten verwendet werden, erhalten werden können.
Weiter betrifft die Erfindung verbesserte Me-C:H-Schichten mit im Vergleich zu den herkömmlichen Schichten deutlich erhöhter Verschleißbeständigkeit.

Gelöst wird diese Aufgabe durch ein Verfahren zur Herstellung von Hartstoffschichten auf Basis von amorphen Kohlenwasserstoff mit einem PVD-(Physical-Vapor-Deposition)-Verfahren, dadurch gekennzeichnet, daß die Substratelektrode mit einer unipolaren oder bipolaren gepulsten Gleichspannung oder einer harmonischen Wechselspannung betrieben wird.

Weiter betrifft die Erfindung Me-C:H-Schichten, die nach dem vorstehenden Verfahren erhalten werden können, und die gegenüber den bekannten Me-C:H-Schichten deutlich niedrigere Verschleißwerte aufweist.

So können mit dem erfindungsgemäßen Verfahren Me-C:H-Schichten mit einer Verschleißbeständigkeit erhalten werden, die um einen Faktor 2 oder mehr besser ist, als die von Me-C:H-Schichten, die mit einem herkömmlichen DC-Prozeß hergestellt sind.

Die Erfindung betrifft zudem ein Schichtsystem, die aus einer Kombination von Schichten auf Basis von amorphen Kohlenwasserstoff mit unterschiedlicher Zusammensetzung bestehen, wobei das Schichtsystem mindestens zwei Schichten unterschiedlicher Zusammensetzung enthält.

Das erfindungsgemäße Verfahren zur Herstellung von Funktions- bzw. Hartstoffschichten auf Basis von amorphen Kohlenwasserstoff kann als eine Kombination der bekannten PVD-Techniken wie DC-Magnetronsputtern oder der Bogenverdampfung, mit einer PACVD-Technik angesehen werden.

Die PACVD-Technik wird hierbei dadurch realisiert, daß die Substrat-Elektrode, die bei dem bisher genutzten PVD-Verfahren nur mit Gleichspannung (DC) betrieben wurde, mit einer unipolaren oder bipolaren gepulsten Gleichspannung oder einer harmonischen Wechselspannung betrieben wird.

Überraschenderweise wurde gefunden, daß durch eine solche Veränderung der Substratbeschaltung Me-C:H-Schichten erhalten werden können, deren Verschleißbeständigkeit in der Größenordnung der Verschleißbeständigkeit von reinen a-C:H-Schichten liegt. So lassen sich nach dem erfindungsgemäßen Verfahren Me-C:H-Schichten erhalten, mit Verschleißwerten, die um einen Faktor 2 und mehr niedriger sind, als die von Me-C:H-Schichten, die nach herkömmlichem Verfahren erhalten werden.

Es hat sich gezeigt, daß durch die erfindungsgemäße Veränderung der Substratbeschaltung die Plasmadichten und damit die Ionenstromdichten am Substrat wesentlich höhere Werte annehmen können als beim herkömmlichen DC-Betrieb. Es wird angenommen, daß als Folge der veränderten Substratbeschaltung eine höhere Vernetzung der amorphen Kohlenwasserstoffbestandteile in der Schicht und damit eine Verbesserung der Verschleißbeständigkeit erzielt wird.

Anders als in den vorstehend beschriebenen Verfahren, die im Hochfrequenzbereich von üblicherweise 13,56 MHz arbeiten, arbeitet die Erfindung vorzugsweise mit Spannungen im Mittelfrequenzbereich. So kann erfindunsgemäß die Frequenz im Bereich von 1 bis 1.000 kHz variieren, wobei ein Bereich von 30 bis 300 kHz und insbesondere von 30 bis 150 kHz besonders bevorzugt ist.

Die Art der Metalle ist an sich nicht beschränkt und es kann jedes geeignete metallische Element oder eine Kombination davon in die erfindungsgemäße Schicht eingebaut werden, die für derartige Schichten geeignet sind. Besonders bevorzugte Beispiele sind metallische Elemente der IV, V und VI Nebengruppe des Periodensystems sowie der III und IV Hauptgruppe des Periodensystems.

Beispiele hierfür sind Titan, Zirkon, Niob, Tantal, Chrom, Wolfram, Bor, Aluminium und Silicium. Besonders bevorzugt sind Titan, Niob und Wolfram.

In der erfindungsgemäßen Me-C:H-Schicht ist das mindestens eine metallische Element vorzugsweise in einem Metall/Kohlenstoff (Me/C)-Verhältnis in einem Bereich von 0,01 bis 0,3 enthalten. Es versteht sich jedoch, daß je nach Anwendungszweck der Metallgehalt größer oder kleiner gewählt werden kann.

Die erfindungsgemäß erhaltenen Me-C:H-Schichten zeigen selbst bei so geringen Metallgehalten wie Me/C < 0,01 nahezu die gleichen Reibungs- und Verschleißeigenschaften wie reine a-C:H-Schichten. Die erfindungsgemäßen Me-C:H-Schichten weisen damit in einem deutlich größeren Bereich der Metallkonzentration erheblich niedrige Verschleißwerte als die herkömmlichen Me-C:H-Schichten auf.

D. h. mit der vorliegenden Erfindung können selbst mit sehr geringen Metallgehalten Schichten erhalten werden, die einerseits niedrige Reibwerte und dennoch hohe Verschleißbeständigkeit aufweisen. Dies ist insbesondere für Anwendungen von Bedeutung, für die eine Hartstoffschicht mit weitgehend a-C:H-Charakter erwünscht ist.

Weiter können in der erfindungsgemäßen Me-C:H-Schicht neben den metallischen Elementen auch nichtmetallische, einschließlich halbmetallischer, Element enthalten sein, wie sie z. B. auch in der vorstehend genannten EP 0 625 588 genannt sind. Besonders geeignete Vertreter sind Elemente der V, VI und VII Hauptgruppe des Periodensystems, wobei Stickstoff, Sauerstoff und/oder Fluor besonders bevorzugt sind. Diese nichtmetallischen Elemente können in der erfindungsgemäßen Schicht in einem Nichtmetall/Kohlenstoff (X/C)-Verhältnis von 0,01 bis 0,3 enthalten sein. Auch hier versteht sich, daß je nach Bedarf der Anteil an Nichtmetallelement höher oder geringer gewählt werden kann.

Daneben wurde gefunden, daß die erfindungsgemäßen Me-C:H-Schichten deutlich geringere Oberflächenrauheiten aufweisen, als die mit dem herkömmlichen DC-Verfahren erhaltenen Schichten. Die mit dem erfindungsgemäßen Verfahren erhaltenen Me-C:H-Schichten können üblicherweise Oberflächenrauheiten in einem Bereich von 0,5 bis 3 nm aufweisen, dagegen zeigen nach dem Stand der Technik erhaltene Schichten Oberflächenrauheiten von 6 nm und mehr.

Mit der erfindungsgemäßen Verfahrensausgestaltung können auch reine a-C:H-Schichten unter Verwendung von Anlagen hergestellt werden, wie sie üblicherweise zur großindustriellen Herstellung von Me-C:H-Schichten eingesetzt werden. Damit ist es erfindungsgemäß möglich, auch reine a-C:H-Schichten im großindustriellen Maßstab herzustellen.

Ermöglicht wird dies, da die erfindungsgemäße Verfahrensausgestaltung z. B. auch eine Beschichtung mit mechanisch durch Blenden abgeschirmten Targets erlaubt. Somit ist eine stufenlose Regulierung des Metallgehalts in der Funktionsschicht bis hin zur reinen a-C:H-Schicht möglich.

Gemäß einer weiteren Ausführungsform ist die erfindungsgemäße Funktionsschicht eine Mehrlagenschicht, die aus mindestens zwei Schichten auf Basis von amorphen Kohlenwasserstoff besteht, wobei die einzelnen Schichten unterschiedliche Komponenten aufweisen. Dies bedeutet, daß das erfindungsgemäße Schichtsystem Schichten aus reinen a-C:H-Schichten und daneben Schichten enthalten kann, die neben den Basiselementen Kohlenstoff und Wasserstoff noch zusätzliche Elemente wie metallische Elemente und/oder halbmetallische Elemente und/oder nichtmetallische Elemente aufweisen können, wie sie vorstehend für derartige einfache Schichten beschrieben worden sind. Dies umfaßt auch Schichten mit denselben Elementen aber in unterschiedlichen Konzentrationen. Gemäß einer bevorzugten Ausführungsform setzt sich die Mehrlagenschicht aus einer Kombination von a-C:H mit Me-C:H-Schichten zusammen.

Die Schichtdicken für die Einzelschichten und das Schichtsystem können je nach Bedarf und Anwendungsfall unterschiedlich gewählt werden. So können so dünne Einzelschichten von bis zu 1 nm erhalten werden, wobei üblicherweise der Bereich für Einzelschichten von einigen nm bis zu mehreren µm gewählt wird. Das vorstehend gesagte für die Einzelschichten gilt selbstverständlich auch für das Schichtsystem. So kann eine Gesamtschichtdicke von wenigen nm aber auch in einem Bereich von 10 nm bis 15 µm, vorzugsweise 100 nm bis 15 µm und insbesondere 500 nm bis 5 µm, gewählt werden.

Wie bereits vorstehend erwähnt, kann die erfindungsgemäße Verfahrensausgestaltung der Substratbeschaltung mit gepulstem Gleichstrom oder harmonischer Wechselfrequenz ohne weiteres mit herkömmlichen Anlagen unter den herkömmlichen Verfahrensbedingungen durchgeführt werden.
So kann bei der erfindungsgemäßen Verfahrensausgestaltung eine Substrattemperatur von unterhalb 200° C erreicht werden, wie sie auch bei herkömmlichen PVD-Verfahren eingesetzt wird.

Mit der Erfindung wird eine Möglichkeit zur Verfügung gestellt, Hartstoffschichten auf Basis von amorphem Kohlenwasserstoff für die unterschiedlichsten Anwendungszwecke im großindustriellen Maßstab herzustellen.

Nachfolgend wird die Erfindung anhand von Beispielen veranschaulicht.

### Beispiele 1 bis 3 und Vergleichsbeispiele 1 bis 3:

Die Schichtabscheidung erfolgte in allen Beispielen und Vergleichsbeispielen in einer Gleichstrom-Magnetron-Sputteranlage, wobei mit unbalancierten Magnetrons gearbeitet wurde. Das Targetmaterial war Titan. Die Beschichtungsprozesse waren jeweils in vier Schritte unterteilt: (1) Substrat-Reinigung durch lonenätzen (Ar⁺), wobei die Targets durch eine Blende (Shutter) abgedeckt sind, (2) Öffnen der Shutter und Aufbringen einer metallischen Haftvermittlerschicht (Ti) durch nichtreaktives Sputtern von Titantargets mit Argon, (3) Überleiten in den reaktiven Sputterprozeß durch langsame Zugabe des Reaktivgases C₂H₂ zum Sputtergas. Dabei wird der C₂H₂-Gasfluß in einer Rampe linear mit der Zeit bis zum festgelegten Endwert gesteigert, (4) Abscheidung der Ti-DLC-Schicht mit einem konstanten C₂H₂-Fluß.

Bei der Abscheidung von Me-C:H-Schichten läßt sich der Metallgehalt der Schichten eindeutig über den C₂H₂-Fluß einstellen.

Es wurden zwei verschiedene Prozeßführungen gewählt. In einer ersten Serie (Vergleichsbeispiele) lag am Substrat eine negative Gleichspannung (DC) an, die im Prozeßschritt (4) variiert wurde.

In einer zweiten Serie (Beispiele) wurde das Substrat mit harmonischen Mittelfrequenzspannungen (40 kHz) angeregt. Die Schichtdicken lagen in beiden Serien zwischen 2,5 und 3,5 µm. Die Reaktivgasanteile im Sputtergas waren bei beiden Serien gleich groß.
Zum Vergleich der Schichten wurden die Schichtzusammensetzungen mittels Elektronenstrahl-Mikroanalyse (EPMA) und der abrasive Verschleiß gemessen.

In **Tabelle 1** sind die Ergebnisse dargestellt. Es ist klar zu erkennen, daß
(i) die Zusammensetzungen der Schichten für beide Serien nahezu gleich ist,
(ii) die Verschleißwerte der mit dem Mittelfrequenzverfahren (MF) abgeschiedenen Schichten nur etwa halb so groß sind wie für alle betrachteten mit dem DC-Verfahren abgeschiedenen Schichten. Die Verschleißwerte wurden mit einem Kalotten (Calo) -Tester ermittelt.
(iii) die Rockwell-Härten (HRC) der Substrate nach den MF-Beschichtungen gegenüber dem Zustand vor den Beschichtungen (HRC ≈ 62) nahezu unverändert sind; dies zeigt, daß die Substrattemperaturen auch bei MF-Anregung unter 200°C bleiben. Demgegenüber weist der erheblich geringere HRC-Wert der mit 600 V DC abgeschiedenen Schicht auf Temperturen von deutlich > 200° C hin.

Diese Ergebnisse, die mehrfach verifiziert wurden, zeigen eindeutig, daß mit dem erfindungsgemäßen Verfahren eine deutlich stärkere Vernetzung der Kohlenwasserstoff-Matrix und damit eine Verschleiß- und Härtesteigerung möglich ist.

### Beispiel 4:

Auch in diesem Beispiel erfolgte die Schichtabscheidung in einer Gleichstrom-Magnetron-Sputteranlage, wobei mit unbalancierten Magnetrons gearbeitet wurde. Im Gegensatz zu den vorhergehenden Beispielen erfolgte die eigentliche Schichtabscheidung bei geschlossenem Shutter. Die Targets waren dabei in Betrieb und unterstützten die Plasmagenerierung in der Beschichtungskammer. Auf den mit der genannten Mittelfrequenzspannung angeregten Substraten wurden Me-C:H-Schichten abgeschieden, die nur sehr wenig Metall (ca. 1 %) enthielten. Obwohl dieser Beschichtungsprozeß noch nicht optimiert ist, lagen die Verschleißwerte dieser Schichten bei 1 *10⁻¹⁵m²/N und waren damit nur um den Faktor 2 schlechter als die der mit einem optimierten Hochfrequenzprozeß abgeschiedenen reinen a-C:H-Schichten. Die Daten zu diesem sind in der letzten Zeile von **Tabelle 1** zusammengefaßt.

Die Verschleißbeständigkeit bzw. der Abrasivverschleiß wurde in allen Beispielen und Vergleichsbeispielen mittels eines modifizierten Standard Calo-wear™-Testverfahren bestimmt. Das modifizierte Standard-Calo-wear-Verfahren ist z. B. beschrieben im Jahresbericht 1998 der Deutschen Fraunhofer-Gesellschaft, Institut Schicht- und Oberflächentechnik, Seiten 53 und 54 sowie in der deutschen Patentanmeldung mit amtlichen Zeichen 198 41 276.2, auf die für die vorliegende Erfindung ausdrücklich Bezug genommen wird.

Für den modifizierten Calo-Test wurde eine Schleifsuspension mit Al₂O₃ als Abrasivmittel mit einer Korngröße von 1 µm gewählt. Der Test wurde mit Stahlkugeln (Durchmesser 3 cm) durchgeführt. Die Aufladekraft betrug 0,54 N, die Einschleifzeit/Anzahl Kugelumdrehungen betrug 180, der Einschleifweg war 16,96 m, die absolute Luftfeuchtigkeit betrug 6,8 bis 7 g H₂O pro kg trockene Luft.

**Tabelle 1**

| | U Bias | Bias Art | d | V_{W} | Härte | Ti | C | O | Ar | N |
|---|---|---|---|---|---|---|---|---|---|---|
| | [V] | | [µm] | [*10⁻¹⁵*m3/Nm] | [HRC] | [at%] | [at%] | [at%] | [at%] | [at%] |
| VB1 | 100 | DC | 3,7 | 4 | 62 | 18 | 80 | 1,7 | 0,5 | 0 |
| VB2 | 300 | DC | 3,4 | 5,5 | 59,2 | 17,5 | 79 | 1,5 | 1,8 | 0 |
| VB3 | 600 | DC | 3,4 | 5,4 | 56 | 20 | 75 | 1,6 | 1,8 | 0 |
| B1 | 100 | MF | 2,9 | 2,8 | 63 | 20,5 | 76,4 | 2,5 | 0,6 | 0 |
| B2 | 200 | MF | 2,8 | 2,2 | 61 | 20 | 77,3 | 1,8 | 0,9 | 0 |
| B3 | 300 | MF | 2,5 | 2,3 | 60,5 | 21,8 | 75,3 | 1,6 | 1,3 | 0 |
| B4 | 600 | MF | 2,1 | 1,0 | 58 | 1,0 | 96,1 | 1,5 | 1,4 | 0 |
| VB = Vergleichsbeispiel B = Beispiel | | | | | | | | | | |

## Patentansprüche

1. Verfahren zur Herstellung von Hartstoffschichten auf Basis von amorphen Kohlenwasserstoff mit einem Physical-Vapor-Deposition-Verfahren (PVD),
**dadurch gekennzeichnet,**
**daß** die Substratelektrode wahlweise mit einer unipolaren oder bipolaren gepulsten Gleichspannung oder einer harmonischen Wechselspannung betrieben wird.

2. Verfahren nach Anspruch 1,
**dadurch gekennzeichnet,**
**daß** die Substratelektrode mit harmonischer Wechselspannung betrieben wird.

3. Verfahren nach einem der Ansprüche 1 oder 2,
**dadurch gekennzeichnet,**
**daß** die Frequenz in einem Bereich von 1 bis 1.000 kHz liegt.

4. Verfahren nach Anspruch 3,
**dadurch gekennzeichnet,**
**daß** die Frequenz in einem Bereich von 30 bis 300 kHz liegt.

5. Hartstoffschicht auf Basis von amorphen Kohlenwasserstoff (a-C:H), erhältlich nach einem Verfahren gemäß einem der Ansprüche 1 bis 4.

6. Hartstoffschicht nach Anspruch 5,
**dadurch gekennzeichnet,**
**daß** die Hartstoffschicht zusätzlich mindestens ein metallisches Element aus gewählt unter Elementen der IV, V und VI Nebengruppe des Periodensystems enthält.

7. Hartstoffschicht nach Anspruch 6,
**dadurch gekennzeichnet,**
**daß** das zusätzlich enthaltend mindestens eine metallische Element ausgewählt ist unter Titan, Zirkon, Niob, Tantal, Chrom und Wolfram.

8. Hartstoffschicht nach Anspruch 6 oder 7,
**dadurch gekennzeichnet,**
**daß** das Metall/Kohlenstoff (Me/C)-Verhältnis in der Schicht in einem Bereich von 0,01 bis 0,3 liegt.

9. Hartstoffschicht nach einem der Ansprüche 6 bis 8,
**dadurch gekennzeichnet,**
**daß** die Hartstoffschicht zusätzlich mindestens ein nichtmetallisches Element ausgewählt unter Elementen der III, IV, V, VI und VII Hauptgruppe des Periodensystems enthält.

10. Hartstoffschicht nach Anspruch 9,
**dadurch gekennzeichnet,**
**daß** das Nichtmetall/Kohlenstoff (X/C)-Verhältnis in der Schicht in einem Bereich von 0,01 bis 0,3 liegt.

11. Hartstoffschicht nach einem der Ansprüche 5 bis 11,
**dadurch gekennzeichnet,**
**daß** die Verschleißbeständigkeit der Schicht mindestens um einen Faktor 2 größer ist als die Verschleißbeständigkeit von Schichten, die mit einem reinen DC-Prozeß erhalten werden.

12. Hartstoffschicht nach einem der Ansprüche 5 bis 11,
**dadurch gekennzeichnet,**
**daß** die Hartstoffschicht eine Rauhheit (Ra) von < 3 nm aufweist.

13. Schichtsystem,
**dadurch gekennzeichnet,**
**daß** das Schichtsystem mindestens zwei Hartstoffschichten nach einem der Ansprüche 5 bis 12 aufweist, wobei die mindestens zwei Schichten eine unterschiedliche Komponentenzusammensetzung und/oder Komponentenkonzentration aufweisen.

14. Schichtsystem nach Anspruch 13,
**dadurch gekennzeichnet,**
**daß** das Schichtsystem mindestens eine a-C:H-Schicht und mindestens eine Me-C:H-Schicht aufweist.

15. Schichtsystem nach einem der Ansprüche 13 oder 14,
**dadurch gekennzeichnet,**
**daß** die einzelnen Schichten eine Dicke in einem Bereich von 1 nm bis 1 µm aufweisen.

16. Schichtsystem nach einem der Ansprüche 13 bis 15,
**dadurch gekennzeichnet,**
**daß** die Gesamtdicke des Schichtsystems in einem Bereich von 10 nm bis 15 µm liegt.
